# EUROPÄISCHE PATENTSCHRIFT

(11) **EP 0 221 287 B1**
(45) Veröffentlichungstag und Bekanntmachung des Hinweises auf die Patenterteilung: **01.09.1993**
(21) Anmeldenummer: 86112425.3
(22) Anmeldetag: 08.09.1986
(51) Int. Cl.: H01L 25/04, H01L 27/142

(54) **Solargenerator**
Solar generator
Générateur solaire

(30) Priorität: 02.11.1985 DE 3538986
(43) Veröffentlichungstag der Anmeldung: 13.05.1987
(73) Patentinhaber: Deutsche Aerospace AG, 81663 München (DE)
(72) Erfinder: Gochermann, Hans, Dipl.-Ing., D-2081 Holm (DE)
(74) Vertreter: Schulze, Harald Rudolf, Dipl.-Ing.

(56) Entgegenhaltungen:
- EP-A- 0 018 924
- FR-A- 2 531 916
- FR-A- 2 550 007
- US-A- 3 565 719
- US-A- 3 844 840
- PATENT ABSTRACTS OF JAPAN Band 7, Nr. 136 (E-181) (1281), 14. Juni 1983; & JP-A-58 50782
- PATENT ABSTRACTS OF JAPAN Band 8, Nr. 13 (E-222) (1450), 20. Januar 1984; & JP-A- 58 175 876
- FUNKSCHAU Nr. 8, April 1983, Seite 12, München; FLEXIBLE ENERGIEVERSORGUNG
- NASA TECH BRIEF NTN83-0634, 1983, Seite 634, Pasadena, Californien, US; N. SARBOLOUKI "Solar-Cell Encapsulation by One-Step Lamination"
- PATENT ABSTRACTS OF JAPAN Band 10, Nr. 75 (E-390) (2132), 25. März 1986; & JP-A- 60 220 977 (HITACHI SEISAKUSHO), 05.11.1985

## Beschreibung

Die Erfindung betrifft einen Solargenerator, dessen kristalline Solarzellen mit zugehörenden elektrischen Anschlüssen und Verbindungsleitungen in einem Verbund aus einem Träger, einer elastischen Schmelzkleberfolie und einer Glasscheibe eingebettet sind.

Derartige Solargeneratoren sind in gerahmter Form für eine terristrische Anwendung allgemein bekannt. Als Anwendungsträger seien Segelboote, Motoryachten oderdergleichen genannt, bei denen die Solargeneratoren Bestandteil eines wartungsfreien Ladesystems für Bootakkumulatoren sind. Auch ist es bekannt, Automobile mit Solargeneratoren auszurüsten. Im Automobilbau werden zukünftig vermehrt Solargeneratoren eingesetzt, die zunächst einmal für die Versorgung von beispielsweise Zusatzlüftern vorgesehen sind. Diese Zusatzlüfter können insbesondere bei Stillstand des Fahrzeuges laufen und dabei das Fahrzeuginnere vor einer starken Überhitzung schützen. Auch ist es möglich, die Fahrzeugbatterien mittels der Solargeneratoren aufzuladen, wobei diese Batterien beispielsweise für den Antrieb mit Elektromotoren herangezogen werden können (Solarauto).

Aus US-A-3 565 719 ist ein Verfahren zur Herstellung eines Solargenerators bekannt, der insbesondere für Anwendungen im Weltraum bestimmt ist, wobei Solarzellen in die Ausnehmungen einer zur Positionierung der Solarzellen dienenden flexiblen Matte eingelegt sind, die Matte zusammen mit den Solarzellen auf einen Mattenträger mit gekrümmter Aufnahmefläche aufgelegt ist, wo sich die Matte aufgrund ihrer Flexibilität der Krümmung der Oberfläche anpaßt, wonach sich die Solarzellenoberflächen daher ebenso annähernd dieser Zellenbefestigungsoberfläche anpassen und anschließend das Solargenerator-Substrat auf der Solarzellen aufgeklebt wird, wobei ein Klemmdruck aufgelegt wird, um das Substrat und die Solarzellen in festem Kontakt während des Aushärtens des Klebstoffes zu halten.

Aus FR-A-2 550 007 ist ein flexibler Solargenerator bekannt, bei dem auf einem flexiblen Substrat ein leitfähiger transparenter Film und ein Halbleiterfilm aus amorphen Silizium aufgebracht sind.

Aus Patent Abstracts of Japan Band 7, Nr. 136 (E181)(1281), 14. Juni 1983, & JP-A-58 50 782 ist eine Dünnfilm-Solarbatterie bekannt, die beispielsweise auf die Scheibe eines Personenkraftwagens aufgebracht werden kann, wobei die Scheibe als das Substrat für die Solarbatterie dient.

Der Erfindung liegt die Aufgabe zugrunde, einen Solargenerator der eingangs genannten Art zuschaffen, der einer vorgegebenen äußeren Kontur angepaßt bzw. in diese Kontur eingepaßt werden kann.

Die Aufgabe wird erfindungsgemäß dadurch gelöst, daß der Solargenerator als gewölbter Verbund mit zumindest eindimensional gebogenen Solarzellen ausgeführt ist.

Ausgestaltungen der Erfindung sind in den Unteransprüchen 2 bis 8 beschrieben.

Ein Verfahren zur Herstellung eines erfindungsgemäßen Solargenerators ist im Anspruch 9 beansprucht.

Eine Ausgestaltung des erfindungsgemäßen Verfahrens ist im Anspruch 10 beschrieben.

Erfindungsgemäße Verwendungen der Solargenerators sind in den Unteransprüchen 11 bis 14 beansprucht.

Durch die Erfindung wird es vorteilhafterweise ermöglicht, einen Solargenerator auch an besonders strömungsgünstigen Konturflächen eines Automobiles, eines Wohnmobiles oder eines Bootes anzuordnen bzw. in das Fahrzeug zu integrieren. Vorteilhafterweise ist auch eine Nachrüstung von bereits vorhandenen Fahrzeugen gewährleistet. In der Zeichnung ist ein Ausführungsbeispiel nach der Erfindung dargestellt, und zwar zeigen:
Figur 1 einen als Schiebedach eines Personenkraftwagens verwendeten Solargenerator,
Figur 2 einen Schnitt gemäß der Linie A -A aus Figur 1, und
Figur 3 einen Solargenerator, der partieller Bestandteil einer PKW-Heckscheibe ist.

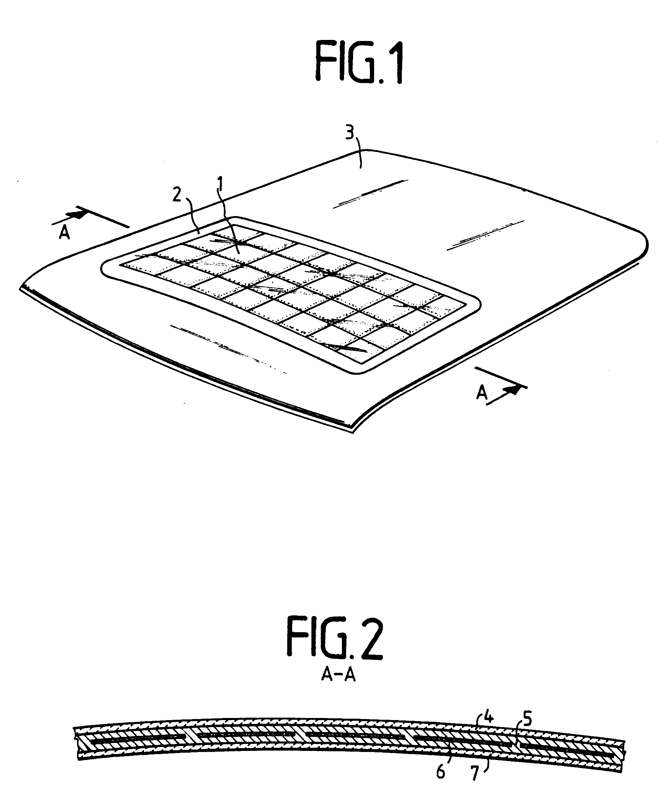

In Figur 1 weist das Dach 3 eines Fahrzeuges ein Schiebedach 2 auf, in dem ein Solargenerator 1 integriert ist. Der Solargenerator ist als gewölbter Verbund mit teilweise eindimensional bzw. teilweise zweidimensional gebogenen Solarzellen ausgeführt. Er weist einen Träger 7 und eine Glasscheibe 4 auf, die thermisch vorgeformt und paarweise hergestellt sind und zwischen denen eine elastische Schmelzkleberfolie 5 sowie die gebogenen Solarzellen 6 angeordnet sind (vgl. Figur 2). Als Träger 7 kommen eine Glasscheibe, ein Blech, eine Folie, vorzugsweise eine durchsichtige Folie, oderdergleichen in Frage.

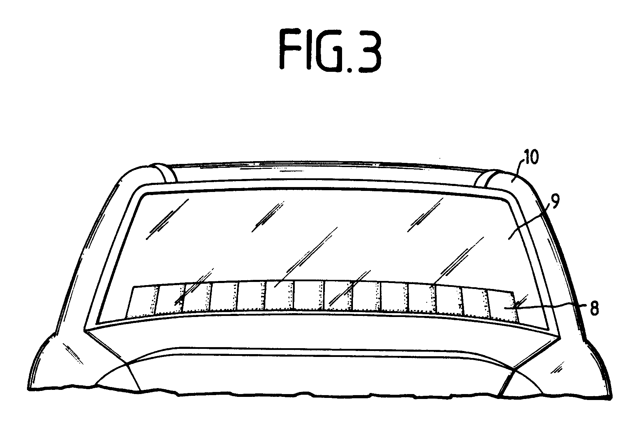

Der gewölbte Solargenerator-Verbund kann integraler Bestandteil eines Fahrzeuges beispielsweise eines PKW, eines LKW, eines Wohnmobils oder eines Bootes sein. Neben der Verwendung als Schiebedach ist beispielsweise eine Anwendung als Spoiler, als Fahrzeugdach, als Kofferraumhaube oder als partieller Bestandteil einer Fahrzeugscheibe vorgesehen. Das letztgenannte Beispiel ist aus Figur 3 ersichtlich, wo ein gewölbter Solargenerator 8 partieller Bestandteil einer Fahrzeugrückscheibe 9 ist. Das Fahrzeugdach ist in diesem Beispiel mit 10 bezeichnet.

Es ist vorgesehen, den gewölbten Solargenerator in seiner Form der aerodynamischen Form eines Fahrzeuges anzupassen. Auch ist die Verwendung von chemisch gehärteten Glasscheiben vorgesehen, durch die eine Reduzierung der Dicke des Generators und seines Gewichtes erzielt wird.

Ein gewölbter Solargenerator kann beispielsweise dadurch hergestellt werden, daß der Träger 7 und die Glasscheibe 4 entsprechend der gewünschten Wölbung des Verbundes vorgeformt werden. Zwischen dem Träger 7 und der Glasscheibe 5 werden dann die Solarzellen 6 und die Schmelzkleberfolien 5 eingelegt, wobei diese eingelegten Bauteile durch äußeren mechanischen Druck auf den Träger 7 und die Glasscheibe 5 näherungsweise der Wölbung des Verbundes angepaßt werden. Durch einen Temperaturvakuumprozeß werden die Schmelzkleberfolie 5 und die Solarzellen 6 des gewölbten Träger 7 und der gewölbten Glasscheibe 5 angepaßt und mit diesen Bauelementen zu einem gewölbten Verbund verschmolzen. Es sei noch erwähnt, daß die Schmelzkleberfolien 5 nach ihrer Verschmelzung praktisch eine einzige Folie bilden.

Anstelle der oben angesprochenen chemisch gehärteten Glasscheiben 4 sind auch Glasscheiben 4 verwendbar, die thermisch gehärtet sind. Als Glasmaterial kommt Weißglas infrage, das im Bereich des Lichtes, das für die Solarzellen besonders empfindlich ist, praktisch keine Absorption aufweist. Anstelle der Glasscheiben 4 können auch durchsichtige Folien vorgesehen werden.

## Patentansprüche

1. Solargenerator, dessen kristalline Solarzellen mit zugehörenden elektrischen Anschlüssen und Verbindungsleitungen in einem Verbund aus einem Träger, einer elastischen Schmelzkleberfolie und einer Glasscheibe eingebettet sind, wobei der Solargenerator als gewölbter Verbund mit zumindest eindimensional gebogenen Solarzellen (6) ausgeführt ist.

2. Solargenerator nach Anspruch 1, gekennzeichnet durch eine Glasscheibe als Träger (7).

3. Solargenerator nach Anspruch 1, dadurch gekennzeichnet, daß als Träger (7) ein Blech vorgesehen ist.

4. Solargenerator nach Anspruch 1, gekennzeichnet durch eine Folie als Träger (7).

5. Solargenerator nach Anspruch 4, gekennzeichnet durch eine durchsichtige Folie.

6. Solargenerator nach Anspruch 1 oder 2, gekennzeichnet durch chemisch gehärtete Glasscheiben (4).

7. Solargenerator nach Anspruch 1 oder 2, gekennzeichnet durch thermisch gehärtete Glasscheiben (4).

8. Solargenerator nach einem der Ansprüche 1, 2, 6 oder 7, gekennzeichnet durch eine Glasscheibe (4) aus Weißglas, die im Bereich des Lichtes, für das die Solarzellen besonders empfindlich sind, praktisch keine Absorption aufweist.

9. Verfahren zur Herstellung eines Solargenerators nach einem der Ansprüche 1 bis 8, wobei der Träger (7) und die Glasscheibe (4) entsprechend der gewünschten Wölbung des Verbundes vorgeformt werden, zwischen dem Träger (7) und der Glasscheibe (4) die Solarzellen (6) und die Schmelzkleberfolie (5) eingelegt werden, die Solarzellen und die Schmelzkleberfolie (5) durch äußeren, mechanischen Druck auf den Träger (7) und die Glasscheibe näherungsweise der Wölbung des Verbundes angepaßt werden und durch einen Temperatur-Vakuumprozeß die Schmelzkleberfolie (5) und die Solarzellen (6) dem gewölbten Träger (7) und der gewölbten Glasscheibe (4) angepaßt und mit diesen Bauelementen zu einem gewölbten Verbund verschmolzen werden.

10. Verfahren nach Anspruch 9, dadurch gekennzeichnet, daß der Verbund einen Träger (7) und eine Glasscheibe (4) aufweist, die thermisch vorgeformt und paarweise hergestellt werden.

11. Verwendung des Solargenerators nach einem der Ansprüche 1 bis 5 als integraler Bestandteil eines Fahrzeuges (PKW, LKW, Wohnmobil, Boot oder dergleichen).

12. Verwendung des Solargenerators nach Anspruch 11 als Schiebedach (2).

13. Verwendung des Solargenerators nach Anspruch 11 als Spoiler.

14. Verwendung des Solargenerators nach Anspruch 2 oder 5 als partieller Bestandteil einer Fahrzeugscheibe (9).

## Claims

1. Solar generator, the crystalline solar cells of which are embedded together with associated electrical terminals and connecting leads in a composite of a carrier, a resilient fusion adhesive film and a glass pane, wherein the solar generator is constructed as a curved composite with solar cells (6) curved in at least one dimension.

2. Solar generator according to claim 1, characterised by a glass pane as carrier (7).

3. Solar generator according to claim 1, characterised thereby that a metal sheet is provided as carrier (7).

4. Solar generator according to claim 1, characterised by a film as carrier (7).

5. Solar generator according to claim 4, characterised by a transparent film.

6. Solar generator according to claim 1 or 2, characterised by chemically hardened glass panes (4).

7. Solar generator according to claim 1 or 2, characterised by thermally hardened glass panes (4).

8. Solar generator according to one of claims 1, 2, 6 or 7, characterised by a glass pane of flint glass which has practically no absorption in the range of light for which the solar cells are particularly sensitive.

9. Process for the manufacture of a solar generator according to one of claims 1 to 8, wherein the carrier (7) and the glass pane (4) are preshaped in correspondence with the desired curvature of the composite, the solar cells (6) and the fusion adhesive film (5) are inserted between the carrier (7) and the glass pane (4), the solar cells and the fusion adhesive (5) are approximately matched to the curvature of the composite by external mechanical pressure on the carrier (7) and the glass pane, and the fusion adhesive film (5) and the solar cells (6) are matched to the curved carrier (7) and the curved glass pane (4) and coalesced with these components into a curved composite by a temperature-vacuum process.

10. Process according to claim 9, characterised thereby that the composite comprises a carrier (7) and a glass pane (4) which are thermally preshaped and produced as a pair.

11. Use of the solar generator according to one of claims 1 to 5 as an integral component of a vehicle (passenger vehicle, freight vehicle, mobile home, boat or the like).

12. Use of the solar generator according to claim 11 as a sliding roof (2).

13. Use of the solar generator according to claim 11 as a spoiler.

14. Use of the solar generator according to claim 2 or 5 as a partial component of a vehicle window pane.

## Revendications

1. Capteur solaire photovoltaïque dont les cellules solaires cristallines avec les bornes et lignes de connexion électriques coordonnées sont noyées dans une construction en sandwich composée d'un support, d'une feuille élastique de colle à fusion et d'une plaque de verre, capteur qui est réalisé comme une construction en sandwich bombée avec des cellules solaires (6) courbées suivant au moins une dimension.

2. Capteur solaire selon la revendication 1, caractérisé par une plaque de verre comme support (7).

3. Capteur solaire selon la revendication 1, caractérisé en ce que le support (7) est une tôle.

4. Capteur solaire selon la revendication 1, caractérisé par une feuille comme support (7).

5. Capteur solaire selon la revendication 4, caractérisé par une feuille transparente.

6. Capteur solaire selon la revendication 1 ou 2, caractérisé par des plaques de verre (4) trempées chimiquement.

7. Capteur solaire selon la revendication 1 ou 2, caractérisé par des plaques de verre trempées thermiquement.

8. Capteur solaire selon une des revendications 1, 2, 6 ou 7, caractérisé par une plaque de verre (4) en verre incolore, qui ne présente pratiquement pas d'absorption dans le domaine de longueur d'onde de la lumière auquel les cellules solaires sont particulièrement sensibles.

9. Procédé pour la fabrication d'un capteur solaire photovoltaïque selon une des revendications 1 à 8, selon lequel on préforme le support (7) et la plaque de verre (4) en conformité avec le bombement désiré de la construction en sandwich, on dispose les cellules solaires (6) et la feuille (5) de colle à fusion entre le support (7) et la plaque de verre (4), on adapte les cellules solaires et la feuille (5) de colle à fusion approximativement au bombement de la construction en sandwich par une pression mécanique extérieure sur le support (7) et la plaque de verre et on adapte la feuille (5) de colle à fusion et les cellules solaires (6) au support (7) bombé et à la plaque de verre (4) bombée par un processus de création du vide utilisant la température, et on les assemble avec ces éléments, par fusion, en une construction en sandwich bombée.

10. Procédé selon la revendication 9, caractérisé en ce que l'on réalise la construction en sandwich avec utilisation d'un support (7) et d'une plaque de verre (4) que l'on préforme thermiquement et que l'on produit par paire.

11. Utilisation du capteur solaire selon une des revendications 1 à 5 comme partie intégrante d'un véhicule ou d'un autre moyen de transport (voiture de tourisme, camion, camping-car, bateau ou analogue).

12. Utilisation du capteur solaire selon la revendication 11 sous la forme d'un toit coulissant (2).

13. Utilisation du capteur solaire selon la revendication 11 sous la forme d'un "spoiler".

14. Utilisation du capteur solaire selon la revendication 2 ou 5 en tant que partie constitutive d'une vitre de véhicule (9).
